Europäisches Patentamt

European Patent Office

Office européen des brevets

(19)

(11) Publication number: **0 042 604**
**B1**

(12) **EUROPEAN PATENT SPECIFICATION**

(45) Date of publication of patent specification: **15.03.89**

(51) Int. Cl.⁴: **H 01 L 27/14,** H 04 N 3/14,
H 01 L 27/06

(21) Application number: **81104734.9**

(22) Date of filing: **19.06.81**

(54) Selective access array integrated circuit.

(30) Priority: **19.06.80 US 161177**

(43) Date of publication of application:
**30.12.81 Bulletin 81/52**

(45) Publication of the grant of the patent:
**15.03.89 Bulletin 89/11**

(84) Designated Contracting States:
**DE GB**

(56) References cited:
**US-A-3 617 823**
**US-A-3 849 678**

(73) Proprietor: **Rockwell International Corporation**
**2230 East Imperial Highway**
**El Segundo, California 90245 (US)**

(72) Inventor: **Sclar, Nathan**
**23634 Decorah Road**
**Diamond Bar, Ca. 91765 (US)**

(74) Representative: **Wagner, Karl H.**
**WAGNER & GEYER Patentanwälte**
**Gewuerzmuehlstrasse 5 Postfach 246**
**D-8000 München 22 (DE)**

EP 0 042 604 B1

Courier Press, Leamington Spa, England.

## Description

### Technical field of the invention

The invention relates to access circuits for electronic device arrays implemented on the surface of a semiconductor wafer, and in particular to selective access circuits which permits simultaneous and continuous readout from an arbitrarily selected arrangement of devices in the array.

### Background of the invention

Various types of integrated circuits including an array of substantially identical electronic detector array devices on one surface of a semiconductor body, and a plurality of electronic access devices associated therewith are known in the prior art. Many of such circuits are implemented with the devices on one side of the array, and the access circuits on the other side. U.S. Patent No. 3,849,678 discloses a photo detector array implemented on one side of a semiconductor wafer and an array of MOSFET switches on the other side of the wafer to enable scanning of the array elements. U.S. Patent No. 4,142,207 and 4,143,269 disclose an imaging system including a MOS field effect transistor switching matrix and a ferroelectric detector matrix located on opposite sides of a heat sink. Other patents such as 3,593,067, and 3,101,049, and 3,604,987 and 3,617,823 and 3,689,900 and 3,735,137 and 3,792,258 disclose various semiconductor devices in which active circuit elements are implemented on both sides of the semiconductor body. In each of the cited patents, the array elements are read out sequentially through a common signal readout path.

Such detector configurations and imaging systems of the prior art are directed to particular applications which are not associated with the problem of simultaneously accessing and reading or writing from an arbitrarily arranged plurality of electronic devices in the array. Prior to the present invention, there has not been an integrated circuit which permits simultaneous access to such an arrangement of electronic devices in an array.

### Summary of the invention

Briefly, and in general terms, the invention relates to selective access circuits for electronic device arrays, and more particularly to selective access circuits implemented on a common semiconductor body together with the array of electronic devices.

The present invention as defined in the claims provides a selective access array comprising a common body of semiconductor material having a first and a second major surface, a plurality of substantially identical electronic devices implemented in a first array on the first major surface, a plurality of electronic access devices implemented in a second array on the body which provides access to the electronic devices in the first array, and access means implemented on the body to electronically sample the outputs of selected electronic devices. The access means permits the simultaneous access of an arbitrarily arranged pattern of the electronic devices in the array. Moreover, the conduction path to such devices can remain on a predetermined period of time, thereby permitting external circuits to continuously monitor selected devices.

The novel features which are considered as characteristic for the invention are set forth in particular in the appended claims. The invention itself, however, both as to its construction and its method of operation, together with additional objects and advantages thereof will be best understood from the following description of specific embodiments when read in connection with the accompanying drawings.

### Brief description of the drawings

Fig. 1 is a plan view of the electronic device portion of the selective access array integrated circuit illustrating one possible arrangement of an array of impurity doped silicon infrared photoconductors according to the present invention;

Fig. 2A is a highly enlarged plan view of a first layer of the access circuit portion of the selective access array integrated circuit according to the present invention;

Fig. 2B is a view of Fig. 2A showing how a conducting path is formed between a peripheral contact and a selected element;

Fig. 3 is a highly enlarged plan view of a second layer of the access circuit portion of the selective access array integrated circuit to the present invention;

Fig. 4 is a highly enlarged plan view of a third layer of the access circuit portion of the selective access array integrated circuit according to the present invention;

Fig. 5 is a plan view of one embodiment of the access circuit portion of the selective access array integrated circuit according to the present invention;

Fig. 6 is a perspective cutaway view of the integrated circuit through the 6—6 line shown in Fig. 5;

Fig. 7 is a cross-sectional view of the integrated circuit through the 7—7 line shown in Fig. 5;

Fig. 8 is a plan view of another embodiment of the access circuit portion of the selective access array integrated circuit according to the present invention;

Fig. 9 is a circuit schematic of the select transistors shown in Fig. 8.

### Description of the preferred embodiment

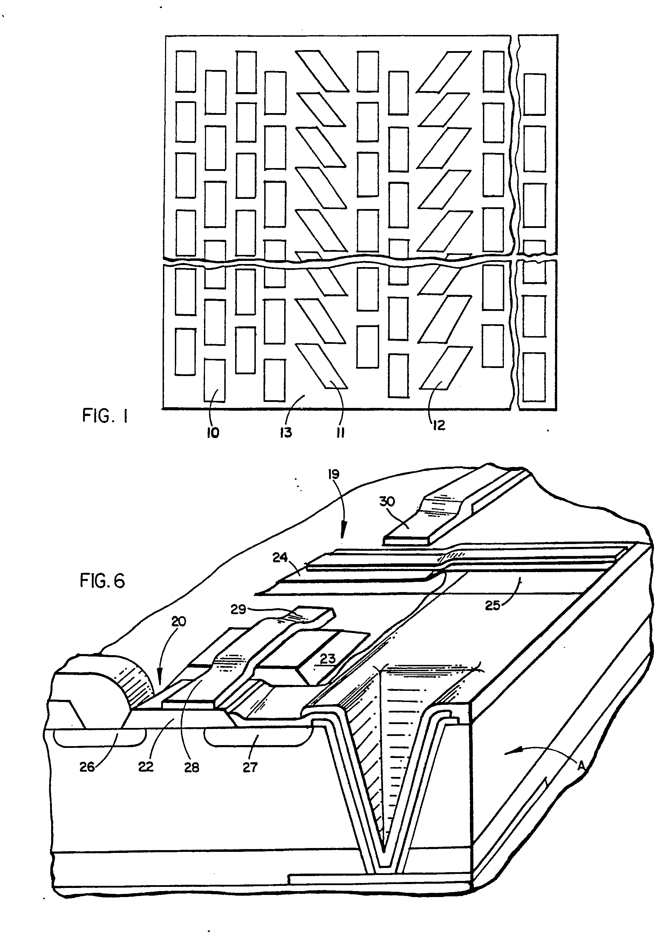

Fig. 1 is a top plan view of the electronic device portion of the selective access array circuit implemented on a first major surface of a semiconductor body according to the present invention.

The circuit according to the present invention is implemented on a body of semiconductor material of a first conductivity type. In a preferred embodiment of the present invention, the body of semiconductor material is an n-type wafer, with a patterned layer of n-type semiconductor material formed by implantation of a dopant species on a first flat major surface thereof. On a second opposite and parallel flat major surface of the semiconductor body, a layer of p-type semiconductor material is formed on the body by epitaxial deposition, and a surface layer of n-type semiconductor material is subsequently formed over the p-type layer.

A plurality of electronic devices are implemented on a first major surface of the semiconductor body. The location of such devices are represented in Fig. 1 by the plurality of quadrangles 10, 11 and 12. The devices may vary in size, shape, composition, and function, and the use of rectangles 10 and parallelograms 11 and 12 shown in Fig. 1 are merely illustrative. Such devices may comprise memory or storage cells, radiative cells, photoconductive cells, or other devices. In the example and embodiment we consider here, the regions 10, 11 and 12 form a detection array of photoconductive cells, although the present invention is not intended to be limited to such application.

The geometry of the detector array can be optimized for various system applications. It can consist of substantial identical square or rectangular detectors arranged in a closely packed two dimensional array. Alternatively, one dimension can be elongated and the columns overlapped. Other orientations are also possible in which selected columns of detectors are placed at angles in a chevron configuration. Fig. 1 illustrates an array containing overlapped columns and a chevron structure. This cell geometry has been chosen to facilitate the tracking of imaged targets as the array is optically scanned. The specific geometry of the detector array can be defined by masking and etching according to techniques known in the art.

The regions defined by the quadrangles 10, 11 and 12 form radiation transmissive but electrically conducting windows. The windows are surrounded by radiation opaque areas 13 which may be formed from a layer of aluminum deposited over an oxide layer on the first major surface of the semiconductor body. This aluminum layer contacts the windows and provides a common electrical contact to the detectors. In a preferred embodiment of the present invention, each transmissive window corresponds to a single discrete photoconductive device formed in the semiconductor body beneath the window.

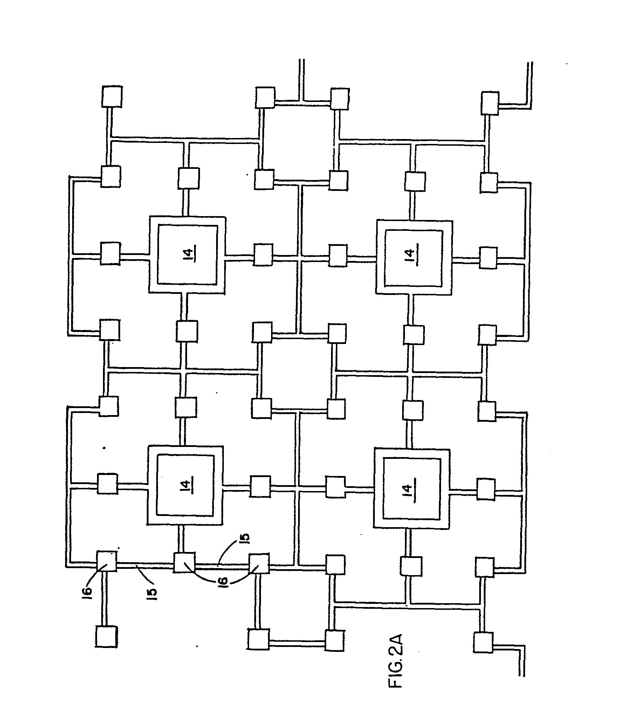

Fig. 2A is a plan view of a portion of the second major surface of the semiconductor wafer through a first plane in the semiconductor body and parallel to the surface on which the selective access array according to the present invention has been implemented. This view shows a portion of the buried contacts 14 of four detectors which have been exposed by preferential etch, and an array of "mini-bus" conducting lines 15 lying between the detectors and MOSFET devices in the first plane. Electrical connection between these lines is afforded by the MOSFET selective access devices 16 which are designated for the purpose of pictorial clarity by small rectangles.

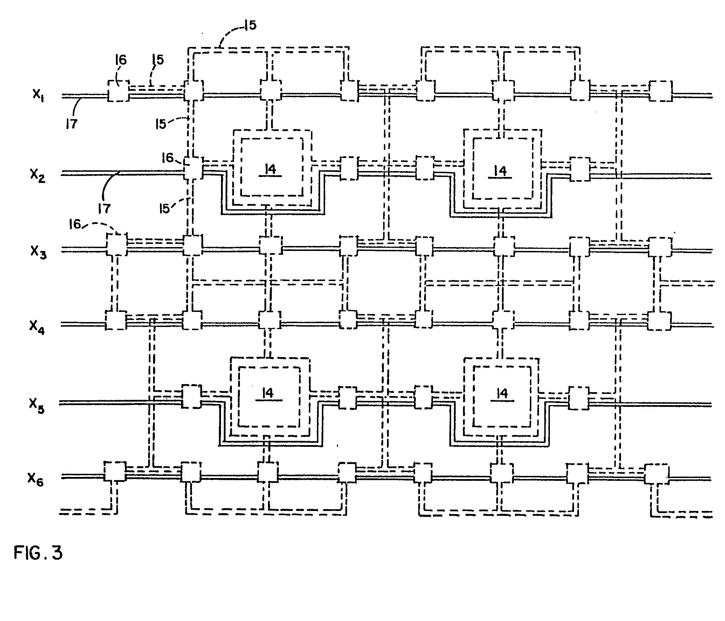

Fig. 3 is a plan view of the same portion of the second major surface of the semiconductor wafer as in Fig. 2A through a second plane parallel to the surface at one "higher" level, or closer to the second major surface of the wafer. The figure shows the buried contact 14, the mini-bus conducting line 15, and the rectangles 16 in dotted lines, while the X-address lines 17 in the second plane are shown by solid lines. The X-address lines 17 are implemented one level above the level shown in Fig. 2A and insulated therefrom, except for making electrical contact with a respective contact (not shown) in the access devices 16.

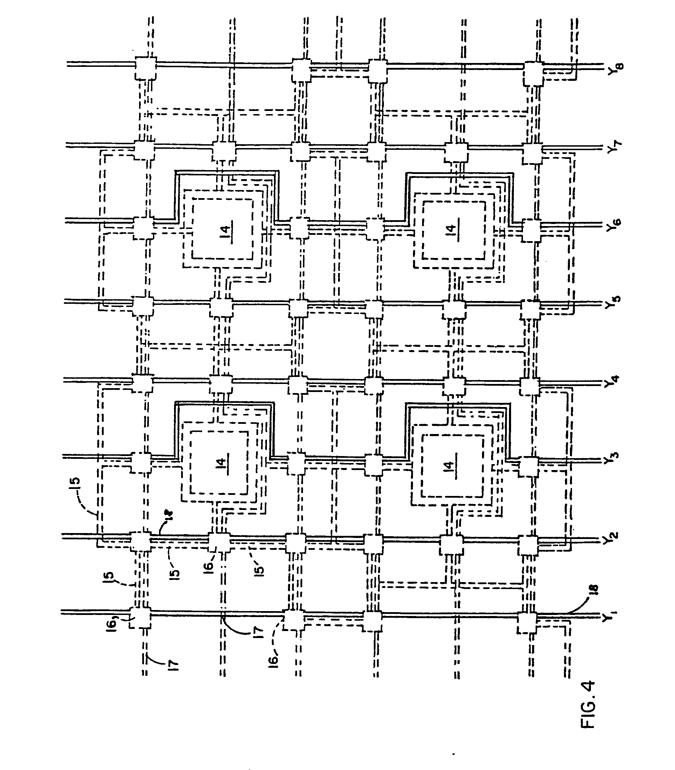

Fig. 4 is a plan view of the same portion of the second major surface of the semiconductor wafer as in Figs. 2A and 3 through a plane parallel to the surface at one level above that shown in Fig. 3. The figure shows the elements of Figs. 2A and 3 in dotted lines, while the Y-address lines 18 in the third plane are shown by solid lines. The Y-address lines are implemented one level above the level shown in Fig. 3, and insulated therefrom, except for making electrical contact with a respective contact (not shown) in the access devices 16.

Each of the access devices 16 makes electrical contact with respective X and Y address lines, as is shown in Figs. 3 and 4. Each of the X and Y addresses are continuous through each device 16, although for simplicity they are shown in segments. They are arranged in rows and columns and are contacted and connected using convention of processing to provide electrical isolation from each other and the substrate.

The access devices 16 consitute switches which connect the mini-bus lines 15 associated therewith together when the X and Y address lines associated with the respective switch are activated.

To create such an electrical connection across the access device 16, a voltage pulse is provided simultaneously on the corresponding X and Y address lines contacting the rectangle 16. In one preferred embodiment of the present invention, the device is kept at crogenic temperatures. These temperatures are required to promote sensitive IR detector response. In such an environment, once the X and Y address lines associated with a particular access device 16 are activated, the select switch is turned on, and remains on for a relatively long time.

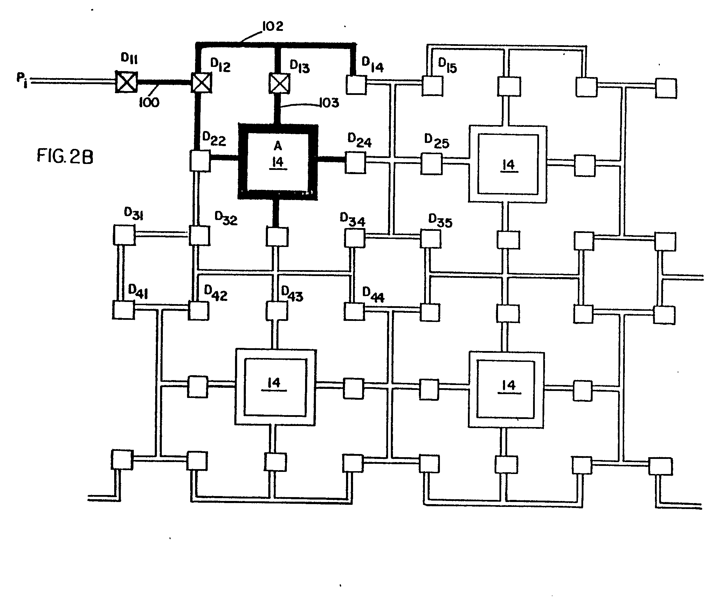

It would be worthwhile at this point to discuss a technique for selecting a given detector and creating a path from the selected detector to the periphery of the chip. Suppose it is desired to selected detector "A", labeled in Figure 2B. A path to detector A is formed by generating successive voltages pulses on the following pairs of address lines $X_1 Y_1$; $X_1 Y_2$; $X_1 Y_3$. When $X_1 Y_1$ is activated, the access device $D_{11}$ is turned on. When $X_1 Y_2$ is activated, the access device $D_{12}$ is turned on and

when $X_1 Y_3$ is activated, access $D_{13}$ is turned on. An electrically conductive path to "A" is created by mini-bus line from an external contact $P_i$ on the chip periphery to device $D_{11}$, then by mini-bus line 100 to device $D_{12}$ then by mini-bus line 102 to $D_{13}$ and finally by mini-bus line 103 to detector "A".

This process is continued until paths are brought to the other external contacts where separate sensing circuits and amplifiers are available for each detector selected. The paths selected are not unique and considerable redundancy is available in selecting a detector and in routing a path from the selected detector to a selected external contact.

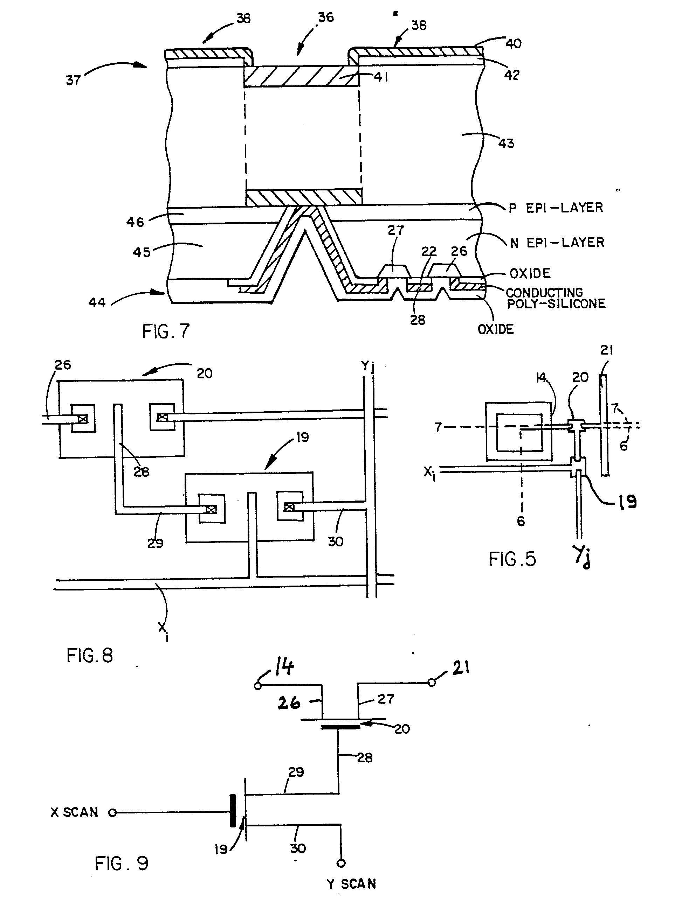

Turning now to Fig. 5, there is shown a plan view of one embodiment of the access circuit portion of the selective access array integrated circuit according to the present invention. An X-address line $X_i$ and a Y-address line $Y_j$ are shown connected to a select transistor shown in a highly simplified manner by the block 19. The current path of the select transistor 19 is also connected to the gate of a second select transistor 20. The main current path of the second select transistor 20 connects the contact 14 of detector A with a mini-bus line 21. Thus when voltage pulses on the select lines $X_i$ and $Y_j$ are provided, the first and second select transistor 19 and 20 are turned on so that the detector A makes electrical contact with the mini-bus line 21. After removal of the voltage pulses, the deposited charge on the gate of transistor 20 is retained for a predetermined period of time so that the detector A is continuously connected to the bus bar line 21 which permits continuous readout from the detector.

Fig. 6 is a perspective cut-away view of the integrated circuit through the 6—6 line shown in Fig. 5. A surface layer of oxide, shown in the Figure as trapezoidal shaped portions, overlies the surface of the semiconductor body. Portions of the oxide layer are specifically designated in the Figure as a gate oxide region 22 associated with field effect transistor 20, a field oxide region 23, another gate oxide region 24 associated with field effect transistor 19, and field oxide region 25.

The diffused regions 26 and 27 of the field effect transistor 20 are also shown, together with gate electrode 28.

Regions 29 and 30 are shown to suggest the locations of the diffused regions of the field effect transistor 19.

Fig. 7 is a cross-sectional view of the semiconductor body through the 7—7 cross-section shown in Fig. 5. The top surface 37 of the semiconductor body consists of opaque areas 38 (also shown in Fig. 1), together with radiation transparent conducting areas 36 which define the sensor area of an electronic device according to the present invention. The opaque areas 38 preferably consist of portions of the first major surface of the semiconductor body which are first covered with a layer 42 of oxide, following an opaque aluminum layer 40 disposed over the oxide layer. The thin layer 40 of aluminum is applied to the surface of the semiconductor body by a process such as sputtering or vacuum deposition as is known in the semiconductor art. The radiation transmissive area 36 consists of a heavily doped impurity layer 41 which is provided on the surface of the semiconductor body by a process of diffusion or ion implantation as is known in the semiconductor art.

The semiconductor body 43 itself, consists of a substrate of semiconductor material such as silicon with an n-type conductivity doped with an n impurity that provides a desired photoconductive spectral response. An n-type impurity is shown in Fig. 7 as an example, although the present invention applies equally well for the device of a substrate with a p-type conductivity. For the n-type substrate, an n-type doped layer 41 with a concentration of $10^{19}$ cm$^{-3}$ is used for the IR transparent conductive layer for each detector.

The second major surface 44 of the semiconductor body includes an n type epitaxial layer 45 on which the semiconductor circuit MOSFET elements are implemented. Layer 45 is isolated from the semiconductor body 43 by a p-type epitaxial layer 46 which is disposed on the surface of the semiconductor body 43.

Fig. 8 is a plan view of another embodiment of the access circuit portion of the selective access array integrated circuit according to the present invention. Since like reference numerals refer to like elements, a detailed description of the Figure is unnecessary.

Fig. 9 is a simplified schematic diagram of the selection circuitry according to the present invention. The circuitry consists of a second field effect transistor 20 having conduction path electrodes one of which electrode is connected to the sensor electrode associated with a sensor element in the semiconductor body and the other electrode being connected with an adjacent mini-bus. The first field effect transistor 19 is also shown having two conduction path electrodes. One of such conduction path electrodes is connected to the gate electrode of the first field effect transistor. The other conduction path electrode of the field effect transistor is connected to the corresponding $Y_j$ input or $Y_j$ address line. The gate electrode of the field effect transistor is connected the $X_i$ input or $X_i$ address line. The net effect of the operation of the two MOSFETs is that when a pulse is applied simultaneously to the X address line and the Y address line, both MOSFET 19 and 20 turn on, thereby conducting the signal which is on the electrode 26 through a MOSFET 20 to the adjacent mini-bus line where it is transferred. If the X scan is not on, the MOSFET 19 is not conductive and therefore, consequently no voltage is applied to the gate 28 and MOSFET 20 is nonconductive. If no voltage is applied to the Y scan, the MOSFET 20 is nonconductive and therefore no voltage is also applied to the gate 28.

It will be obvious to those skilled in the art that the semiconductor device according to the present invention can be implemented with various semiconductor technologies and different combinations of known process steps, and that the preferred embodiments illustrated here are merely exemplary. The depth of penetration of the various zones and regions and in particular the configuration and distance between the active zones of the transistor deices, as well as the concentrations of dopant species, and/or their concentration profiles, can be chosen depending upon the desired properties. These and other variations can be further elaborated by those skilled in the art without departing from the scope of the present invention.

The present invention is also not restricted to the specific semiconductor materials and circuits described. For example, it may be pointed out that semiconductor materials other than silicon, for example $A_{III}$—$B_V$ compounds, may be used. Furthermore, the conductivity types in the embodiment may be interchanged and corresponding to such change, the polarity of the respective operating voltages adapted. Moreover, the voltage level and the static or dynamic nature of the signals applied to the variuous terminals and gates of the device, as well as the voltage sources, may be suitably selected as desired for a particular application.

**Claims**

1. A selective access array integrated circuit comprising:

a common body of semiconductor material (43) having first and second major surfaces (37, 44) and a plurality of electronic devices (10, 11, 12) implemented in a first array on said first major surface, each one of said electronic devices capable of transferring information which changes over a period of time;

a plurality of electronic access elements (16) implemented in a second array, each access element corresponding to at least one of said electronic devices in said first array;

a plurality of signal output pads (Pi) disposed on the periphery of said second major surface of said body for connection to corresponding respective ones of said electronic devices for simultaneously receiving data from said ones of electronic devices and simultaneously transferring such data externally of said circuit in a nonsequential, parallel data manner;

a plurality of electrically conducting lines (15) connecting said electronic devices (10, 11, 12), said electronic access elements (16), and said signal output pads (Pi); and

addressing circuitry (17, 18) for addressing said electronic access elements and selectively turning on predetermined ones of said electronic access elements to provide a plurality of continuous and simultaneous electrical readout paths through said electrically conducting lines, said paths connecting predetermined ones of said signal output pads and an arbitrarily arranged pattern comprising a plurality of said electronic devices.

2. A circuit as defined in claim 1, wherein said access elements (16) are disposed on said second major surface (44) in an array of parallel rows and parallel columns, the rows being disposed perpendicular to the columns.

3. A circuit as defined in either claim 1 or 2 wherein said electronic devices are substantially identical infrared radiation detectors, and each of said electronic access elements comprise a pair of MOS field effect transistors (19, 20).

4. A circuit as defined in claim 3 wherein:

said electronic devices are photoconductive cells;

said first major surface (37) comprises a layer (40) of aluminum over a surface portion of said major surface, and a heavily doped IR transparent impurity layer (41) in window aperture areas (36) of said first major surface where the aluminum layer is absent and said photoconductive cells are formed in said semiconductor body (43);

an n-type epitaxial layer (45) implemented on said second major surface (44) including said plurality of electronic access elements, each element including a pair of MOS field effect transistors (19, 20);

an indentation in said second major surface permits an electrode of one (20) of said MOS field effect transistors to make electrical contact with said semiconductor body (43) in a region directly beneath a window aperture (36) of said first major surface and the corresponding radiation sensitive device.

5. A circuit as defined in any one of claims 1—4 wherein said addressing circuitry comprises an X-address line (17) and Y-address line (18) that together function to select predetermined ones of said electronic access elements (16).

6. A circuit as defined in claim 5, wherein each electronic access element comprises:

a first field effect transistor (19) having first and second conduction path electrodes (30, 29) and a control electrode, said first conduction path electrode (30) being connected to said Y-address line, and said control electrode connected to said X-address line; and

a second field effect transistor (20) having a first conduction path electrode (26) connected to said electronic device, a second conduction path electrode (27) connected to an output line (21), and a control electrode (28) connected to said second conduction path electrode (29) of said first field effect transistor (19).

7. A circuit as defined in claim 6 wherein the second conduction path electrode (27) of said second field effect transistor (20) is connected to an output line (21) extending across said second major surface (44) to the periphery of said second major surface, said output line being connected to one of said signal output pads, such that when one of said Y-address lines (18) and one of said X-address lines (17) is activated, said first and said second transistors (19, 20) are turned on, and information from said corresponding electronic device is transferred continuously through said second field effect transistor (20) to said respective signal output pad.

**Patentansprüche**

1. Integrierte Schaltungsmatrix mit selektivem Zugriff, wobei folgendes vorgesehen ist:

ein gemeinsamer Körper aus Halbleitermaterial (43) mit ersten und zweiten Hauptoberflächen (37, 44) und eine Vielzahl von elektronischen Vorrichtungen (10, 11, 12) ausgeführt in einer ersten Matrix (Anordnung) auf der ersten Hauptoberfläche, wobei jede der elektronischen Vorrichtungen in der Lage ist, sich über eine Zeitperiode ändernde Information zu übertragen;

eine Vielzahl von elektronischen Zugriffselementen (16) implementiert in einer zweiten Anordnung (Matrix), wobei jedes Zugriffselement mindestens einer der elektronischen Vorrichtungen in der ersten Anordnung entspricht;

eine Vielzahl von Signalausgabestellen (Pi) angeordnet am Umfang der zweiten Hauptoberfläche des Körpers zur Verbindung mit entsprechenden Vorrichtungen der elektronischen Vorrichtungen zum gleichzeitigen Empfang von Daten von den erwähnten elektronischen Vorrichtungen und zur gleichzeitigen Übertragung dieser Daten extern zur erwähnten Schaltung in einer nichtsequentiellen parallelen Datenart;

eine Vielzahl von elektrisch leitenden Leitungen (15), welche die elektronischen Vorrichtungen (10, 11, 12), die elektronischen Zugriffselemente (16) und die Signalausgangsstellen (Pi) verbinden; und

Adressierschaltung (17, 18) zum Adressieren der elektronischen Zugriffselemente und zum selektiven Einschalten vorbestimmter elektronischer Zugriffselemente der erwähnten elektronischen Zugriffselemente um eine Vielzahl von kontinuierlichen und gleichzeitigen elektrischen Lesebahnen durch die erwähnten elektrisch leitenden Leitungen vorzusehen, wobei die Bahnen vorbestimmte Stellen der erwähnten Signalausgangsstellen und ein zufällig angeordnetes Muster aus einer Vielzahl der elektronischen Vorrichtungen verbinden.

2. Schaltung nach Anspruch 1, wobei die Zugriffselemente (16) auf der zweiten Hauptoberfläche (44) in einer Anordnung aus parallelen Reihen und parallelen Spalten Angeordnet sind, wobei die Reihen senkrecht zu den Spalten verlaufen.

3. Schaltung nach Anspruch 1 oder 2, wobei die elektronischen Vorrichtungen im wesentlichen identische Infrarotstrahlungsdetektoren sind und jedes der elektronischen Zugriffselemente ein Paar von MOS-Feldeffekttransistoren (19, 20) aufweist.

4. Schaltung nach Anspruch 3, wobei folgendes vorgesehen ist:

die elektronischen Vorrichtungen sind photoleitende Zellen;

die erste Hauptoberfläche (37) weist eine Schicht (40) aus Aluminium über einem Oberflächenteil der Hauptoberfläche auf und eine stark dotierte IR-transparente Störstellenschicht (41) in Fensteröffnungsgebieten (36) der ersten Hauptoberfläche, wo die Aluminiumschicht nicht vorhanden ist und die photoleitenden Zellen in dem Halbleiterkörper (43) ausgebildet sind;

eine n-Typ-Epitaxialschicht (45) ist auf der zweiten Hauptoberfläche (44) umplementiert, und zwar einschließlich der Vielzahl von elektronischen Zugriffselementen, wobei jedes Element ein Paar von MOS-Feldeffekttransistoren (19, 20) aufweist:

eine Vertiefung in der zweiten Hauptoberfläche gestattet einer Elektrode von einem (20) der MOS-Feldeffektransitoren elektrischen Kontakt mit dem Halbleiterkörper (43) herzustellen, und zwar in einer Zone direkt unterhalb einer Fensteröffnung (36) der ersten Hauptoberfläche und der entsprechenden strahlungsempfindlichen Vorrichtung.

5. Schaltung nach einem der Ansprüche 1 bis 4, wobei die Adressierschaltung eine X-Adressenleitung (17) und eine Y-Adressenleitung (18) aufweist, die zusammen arbeiten, um vorbestimmte Elemente der elektronischen Zugriffselemente auszuwählen.

6. Schaltung nach Anspruch 5, wobei jedes elektronische Zugriffselement folgendes aufweist:

einen ersten Feldeffekttransistor (19) mit ersten und zweiten Leitungsbahnelektroden (30, 29) und einer Steuerelektrode, wobei die erste Leitungsbahnelektrode (30) mit der Y-Adressenleitung und die Steuerelektrode mit der X-Adressenleitung verbunden ist;

einen zweiten Feldeffekttransistor (20) mit einer ersten Leitungsbahnelektrode (26) verbunden mit der elektronischen Vorrichtung, eine zweite Leitungsbahnelektrode (27) verbunden mit einer Ausgangsleitung (21) und eine Steuerelektrode (28) verbunden mit der zweiten Leitungsbahnelektrode (29) des ersten Feldeffekttransistors (19).

7. Schaltung nach Anspruch 6, wobei die zweite Leitungsbahnelektrode (27) des zweiten Feldeffekttransistors (20) mit einer Ausgangsleitung (21) verbunden ist, die sich über die zweite Hauptoberfläche (44) zum Umfang der zweiten Hauptoberfläche erstreckt, wobei die Ausgangsleitung verbunden ist mit einer der Signalausgangsstellen derart, daß dann, wenn eine der Y-Adressenleitungen (18) und eine der X-Adressenleitungen (17) aktiviert ist die ersten und zweiten Transistoren (19) und (20) eingeschaltet werden, und wobei Information von der entsprechenden elektronischen Vorrichtung kontinuierlich durch den zweiten Feldeffekttransistor (20) zu der entsprechenden Signalausgabestelle transferiert wird.

**Revendications**

1. Circuit intégré à matrice à accès sélectif, comprenant

un corps commun d'un matériau semi-conducteur (43) ayant une première et une seconde grande face (37, 44) et plusieurs dispositifs électroniques (10, 11, 12) réalisés suivant une première matrice sur la première grande face, chacun des dispositifs électroniques étant capable de transférer une information qui change au cours d'une période,

plusieurs éléments électroniques d'accés (16) réalisés suivant une seconde matrice, chaque élément d'accés correspondant à l'un au moins des dispositifs électroniques de la première matrice,

plusieurs plages (Pi) de sortie de signaux disposées à la périphérie de la seconde grande face du corps et destinées à être connectées à des dispositifs électroniques respectifs correspondants afin qu'elles reçoivent simultanément des données de ces dispositifs électroniques et transférent simultanément ces données à l'extérieur du circuit sous forme de données parallèles non séquentielles,

plusieurs lignes conductrices de l'électricité (15) connectant les dispositifs électroniques (10, 11, 12), les éléments électroniques d'accés (16), et les plages (Pi) de sortie de signaux, et

un circuit (17, 18) d'adressage des éléments électroniques d'accés et de mise sélectivement en fonctionnement des éléments électroniques prédéterminés d'accés afin que plusieurs trajets électriques continus et simultanés de lecture soient formés par l'intermédiaire des lignes conductrices de l'électricité, les trajets connectant des plages prédéterminées de sortie de signaux et un dessin disposé arbitrairement et comprenant plusieurs des dispositifs électroniques.

2. Circuit selon la revendication 1, dans lequel les éléments d'accés (16) sont disposés sur la seconde grande face (44) suivant une matrice comprenant des lignes parallèles et des colonnes parallèles, les lignes étant disposées perpendiculairement aux colonnes.

3. Circuit selon la revendication 1, dans lequel les dispositifs électroniques sont des détecteurs sensiblement identiques d'un rayonnement infrarouge, et chacun des éléments électroniques d'accès comporte deux transistors à effet de champ MOS (19, 20).

4. Circuit selon la revendication 3, dans lequel les dispositifs électroniques sont des cellules photoconductrices,

la première grande face (37) comporte une couche (40) d'aluminium formée sur une partie de la grande face, et une couche (41) très dopée d'impuretés et transparente au rayonnement infrarouge placée dans des zones d'ouvertures de fenêtres (36) de la première grande face dans lesquelles la couche d'aluminium est absente et les cellules photoconductrices sont formées dans le corps semiconducteur (43),

une couche épitaxiale (45) de type n est formée sur la seconde grande face (44) qui comprend plusieurs éléments électroniques d'accès, chaque élément comprenant deux transistors à effet de champ MOS (19, 20), et

une cavité formée dans la seconde grande face permet à une électrode de l'un (20) des transistors à effet de champ MOS d'être en contact électrique avec le corps semiconducteur (43) dans une région qui se trouve juste au-dessous d'une ouverture de fenêtre (36) de la première grande face et du dispositif correspondant sensible au rayonnement.

5. Circuit selon l'une quelconque des revendications 1 à 4, dans lequel le circuit d'adressage comprend une ligne d'adresse X (17) et une ligne d'adresse Y (18) qui assurent ensemble la sélection d'éléments électroniques prédéterminés d'accès (16).

6. Circuit selon la revendication 5, dans lequel chaque élément électronique d'accès comprend

un premier transistor à effet de champ (19) ayant des première et seconde électrodes (30, 29) d'un trajet de conduction et une électrode de commande, la première électrode (30) formant un trajet de conduction étant connectée à la ligne d'adresse Y, et l'électrode de commande étant connectée à la ligne d'adresse X, et

un second transistor à effet de champ (20) ayant une première électrode (26) d'un trajet de conduction connectée au dispositif électronique, une seconde électrode (27) d'un trajet de conduction connectée à une ligne de sortie (21) et une électrode de commande (28) connectée à la seconde électrode (29) du trajet de conduction du premier transistor à effet de champ (19).

7. Circuit selon la revendication 6, dans lequel la seconde électrode (27) du trajet de conduction du second transistor (20) à effet de champ est connectée à une ligne de sortie (21) disposée transversalement sur la seconde grande face (44) jusqu'à la périphérie de la seconde grande face, la ligne de sortie étant connectée à l'une des plages de sortie de signaux de manière que, lorsque l'une des lignes d'adresse Y (18) et l'une des lignes d'adresse X (17) est activée, le premier et le second transistor (19, 20) sont mis à l'état conducteur, et l'information provenant du dispositif électronique correspondant est transféré de façon continue par le second transistor à effet de champ (20) à la plage respective de sortie de signaux.

FIG. I

10    13    11         12

FIG. 6

19

30

24

25

29

23

20

26    22    28    27

A

FIG. 2A

FIG.2B

FIG. 3

4

FIG. 4

FIG. 7

FIG. 8

FIG.5

FIG. 9

P EPI-LAYER

N EPI-LAYER

OXIDE

CONDUCTING
POLY-SILICONE

OXIDE

X SCAN

Y SCAN